# FASCICULE DE BREVET EUROPEEN

(11) **EP 0 430 727 B1**
(45) Date de publication et mention de la délivrance du brevet: **16.08.1995**
(21) Numéro de dépôt: 90403033.5
(22) Date de dépôt: 26.10.1990
(51) Int. Cl.: G11C 5/00, G06F 3/06

(54) **Unité de mémoire de masse électronique sécurisée**
Gesicherte elektronische Massenspeichereinheit
Secure electronic mass-memory unit

(30) Priorité: 01.12.1989 FR 8915914
(43) Date de publication de la demande: 05.06.1991
(73) Titulaire: BULL S.A., 92800 Puteaux (FR)
(72) Inventeur: Carteau, Daniel, F-78180 Montigny le Bretonneux (FR)
(74) Mandataire: Gouesmel, Daniel

(56) Documents cités:
- EP-A- 0 080 875
- IBM TECHNICAL DISCLOSURE BULLETIN, vol. 26, no. 4, septembre 1983, pages 1855- 1857, New York, US; E.D. BAKER et al.: "Electronic diskette unit"
- FUJITSU SCIENTIFIC & TECHNICAL JOURNAL, vol. 21, no. 4, septembre 1985, paes 452-460, Kawasaki JP; M. TAKAMURA et al.: "High-density packaging of main storage"
- IEEE MICRO, vol. 6, no. 1, février 1986, pages 7-15, New York, US; G. NERI et al.: "The modiac multiprocessor-A 286-based design"
- ELECTRONICS COMPONENTS & APPLICATIONS, vol. 6, no. 3, 1984, pages 178-185, Eindhoven, NL; C. MACKENNA et al.: "Backup support gives VMEbus powerful mulitprocessing architecture"
- IBM TECHNICAL DISCLOSURE BULLETIN, vol. 29, no. 5, octobre 1986, pages 2102- 2106, New York, US; "Method for scheduling writes in a duplexed DASD subsystem"

## Description

La présente invention concerne une unité de mémoire de masse électronique sécurisée dont les éléments mémorisants sont constitués par des mémoires à semi-conducteurs, par exemple du type RAM ou EEPROM. Elle est plus particulièrement destinée à être utilisée en tant que sous-système de mémoire de masse dans un système informatique.

On sait qu'un système informatique est constitué d'une unité centrale formée d'au moins un processeur central et d'une mémoire principale à laquelle ce processeur est relié, de différents organes périphériques et d'un processeur d'entrée/sortie assurant le contrôle de l'échange de données entre la mémoire et ces différents organes.

Des contrôleurs de périphériques sont associés aux différents organes périphériques et assurent le transfert physique des données entre l'unité centrale et les périphériques associés à ces différents contrôleurs.

Tous ces éléments constitutifs fonctionnels d'un système informatique sont disposés sur un ensemble de cartes reliées généralement à un même bus de type parallèle qui assure le transport des données entre les différentes cartes et l'alimentation électrique de celles-ci.

Le bus communément appelé MULTIBUS II (marque déposée par la Société INTEL) est l'un des bus les plus couramment utilisés dans la pratique actuelle. Son architecture est structurée autour d'un bus principal de type parallèle normalisé suivant la norme IEEE 1296 (Institute of Electrical and Electronic Engineers). Le MULTIBUS II étant un bus de type fond de panier, la structure physique d'une architecture de système informatique se présente donc sous la forme d'un panier porte-cartes comprenant une pluralité de cartes logiques, les différentes caractéristiques physiques et mécaniques du panier porte-cartes étant définies par la norme précitée.

Parmi les organes périphériques, on relève les mémoires de masse telles que les mémoires à disques magnétiques rotatifs. Ces mémoires à disques magnétiques sont physiquement distinctes des cartes formant le système informatique lui-même et sont reliées à celui-ci par l'intermédiaire de câbles d'interface de type SCSI/IPI normalisés par l'ANSI (American National Standards Institute). Les mémoires à disques magnétiques sont encore largement utilisées en raison de leur faible coût par unité de capacité mémoire (coût de l'unité de capacité, par exemple du kilo ou du mégaoctet).

Toutefois, ces mémoires à disques magnétiques rotatifs présentent les inconvénients suivants : elles comportent une partie mécanique importante, nécessitant une haute précision et par conséquent, coûteuse (dispositif de positionnement des têtes de lecture des informations, moteur d'entraînement en rotation des disques), leur volume est relativement important, et la dépense d'énergie nécessaire au fonctionnement des parties mécaniques essentiellement est non négligeable. Enfin, le temps d'accès aux informations est de l'ordre de 10 à quelques dizaines de millisecondes.

La tendance actuelle dans le développement technologique des mémoires de masse est d'essayer d'obtenir un meilleur temps d'accès et de réduire sensiblement leur encombrement physique. On développe donc à cet effet des mémoires de masse dites mémoires électroniques, ou encore disques électroniques (solid state disc, en anglais) utilisant des mémoires semiconducteurs. Leur temps d'accès est largement inférieur à la milliseconde (c'est-à-dire quelques dizaines de fois inférieure au temps d'accès des mémoires à disques rotatifs les plus performantes) et elles ne comportent pas de partie rotative. Le coût de capacité mémoire unitaire de telles mémoires électroniques reste élevé, une vingtaine de fois plus élevé que celui des mémoires à disques magnétiques. Cependant, le coût de la capacité mémoire unitaire des mémoires électroniques a tendance à diminuer beaucoup plus rapidement que celui des mémoires à disques magnétiques rotatifs et on peut penser que ce coût sera équivalent d'ici quelques années.

Le document IBM Technical Disclosure Bulletin, Vol. 26, No. 4 de septembre 1983 décrit une mémoire de masse électronique ayant les mêmes fonctions qu'une disquette mécanique pour micro-ordinateur. Elle comprend une mémoire de type RAM (qui remplace la disquette mécanique) dans laquelle les données sont transférées depuis un processeur hôte par l'intermédiaire du bus d'entrée-sortie de ce processeur, d'un registre de données et du bus interne d'un microprocesseur de commande appartenant à la dite mémoire de masse, ce dernier organisant les transferts de données entre l'hôte et la mémoire RAM.

De telles mémoires à disques électroniques sont actuellement fabriquées par les constructeurs suivants : IMPERIAL TECHNOLOGY, Inc., 831 S. Douglas Street, El Segundo, Californie (avec son produit appelé Megaram), ou encore NATIONAL ADVANCED SYSTEMS (avec son unité mémoire 7990). Leur capacité mémoire est de l'ordre de quelques dizaines de mégaoctets et leur temps d'accès de quelques dixièmes de millisecondes. Leur débit est extrêmement élevé, de l'ordre de quelques mégabits par seconde.

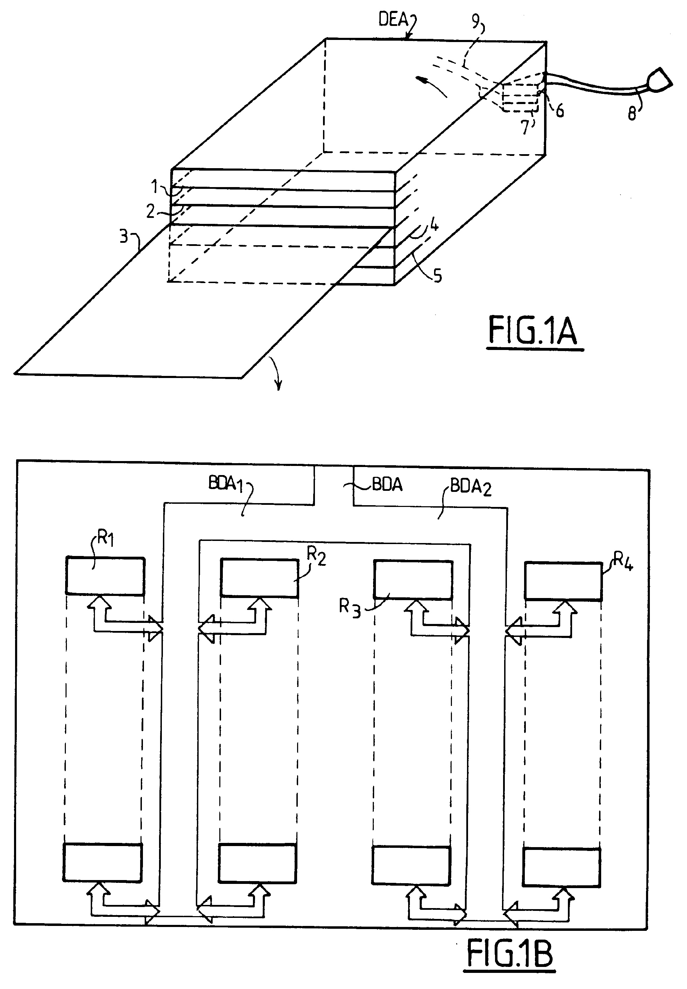

On considère la figure 1 qui montre un tel disque électronique, à savoir DEA, selon l'Art Antérieur, tel que fabriqué par l'une des sociétés précitées.

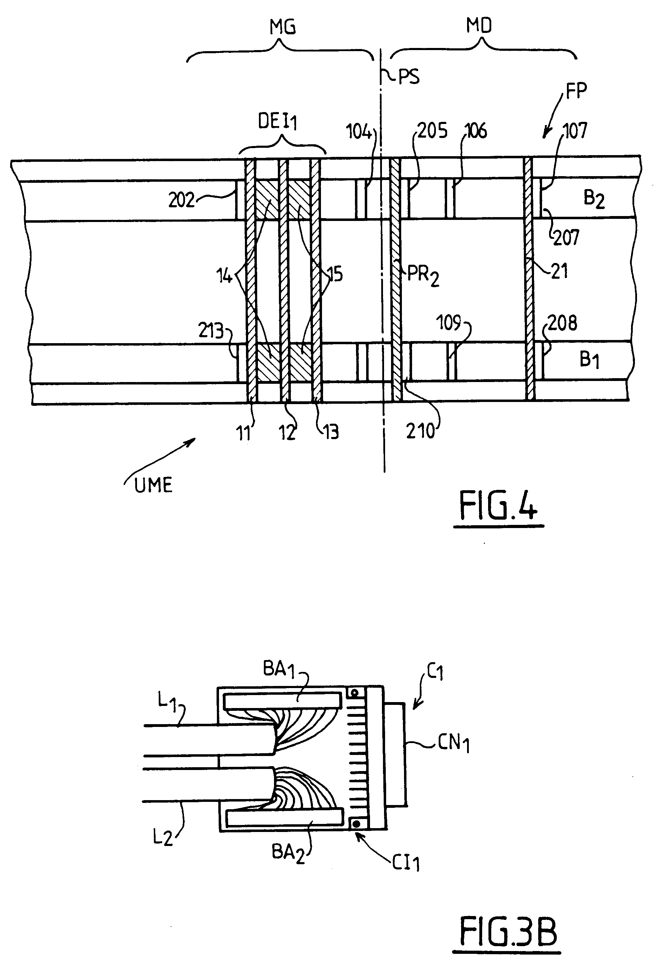

Un tel disque électronique a une forme extérieure parallélépipédique. Il comporte une pluralité de cartes logiques 1 à 5, dont seule la carte 3 est représentée pour simplifier aux figures 1A et 1B. Ces différentes cartes logiques sont parallèles les unes aux autres et comportent une pluralité de colonnes de mémoires à semi-conducteurs par exemple de type RAM. Ces colonnes, au nombre de n, sont désignées respectivement par R₁, ... Rⱼ, ... Rₙ (à la figure 4, on a n = 4, et on a représenté 4 colonnes R₁, R₂, R₃, R₄). Les informations sont écrites à l'intérieur des différentes RAM constituant les différentes colonnes C₁ à Cₙ, de manière à ce que les blocs d'informations soient écrits à la suite les uns des autres, à des adresses qui se suivent, d'une façon analogue à celle utilisée classiquement pour écrire les données dans les mémoires RAM.

Le disque électronique DEA comporte également, visibles sur la partie arrière du boîtier deux connecteurs 6 et 7, permettant de le relier soit à d'autres disques électroniques du même type, soit au contrôleur de périphériques associé à ces différents disques électroniques, par l'intermédiaire de câbles d'interface 8 et 9. Ces câbles 8 et 9 sont des câbles de type SCSI/IPI normalisés par l'ANSI. On voit donc que les disques électroniques du type DEA sont connectés entre eux et connectés à leur contrôleur au moyen de liaisons d'interface du même type que celles utilisées pour les mémoires à disques rotatifs. Cette analogie de connexion avec celle des mémoires à disques rotatifs a conduit les hommes du métier à donner aux unités de mémoires électroniques, le nom de disques électroniques, bien que la forme physique des mémoires électroniques ne soit évidemment pas comparable avec la forme physique des disques magnétiques rotatifs.

Les informations (données et adresses où sont localisées ces données à l'intérieur des RAM) provenant de ou allant vers les mémoires RAM sont transportées par un bus BDA. Celui-ci se compose en fait d'un bus de données et d'un bus d'adresses. (Pour simplifier à la figure 1B, on a fait figurer ces deux bus sous la forme d'un seul). Le bus BDA se subdivise au niveau des colonnes de RAM en deux branches BDA₁ alimentant les colonnes R₁ et R₂ et BDA₂ alimentant les colonnes R₃ et R₄.

On note que l'encombrement physique des disques électroniques tel que DEA est équivalent à celui des mémoires à disques magnétiques rotatifs. Par ailleurs, si le temps d'accès aux informations contenues dans n'importe laquelle des cartes d'un disque électronique est de l'ordre de quelques dixièmes de millisecondes, le fait de faire transiter les informations d'un contrôleur à un disque électronique ou vice-versa par l'intermédiaire de liaisons d'interface du type des liaisons 8 et 9, augmente considérablement le temps d'accès, de l'ordre de 1 à 2 millisecondes.

La présente invention permet de remédier à ces inconvénients en disposant le(s) plan(s) mémoire de la fonction disque électronique (cartes telles que 1 à 5), non plus à distance du contrôleur et des processeurs du système informatique comme cela est le cas pour une mémoire à disques magnétiques rotatifs classique ou encore un disque électronique de l'Art Antérieur (en passant par le même type de liaison d'interface), mais au sein même d'un ensemble compact rassemblant les plans mémoire des unités à disques électroniques, le(s) contrôleurs(s) de celles-ci et une partie des processeurs du système informatique auquel appartient le sous-système comprenant les unités à disques électroniques. Cet ensemble compact revêt, de préférence, la forme d'un panier porte-cartes.

Selon l'invention, le sous-système informatique à mémoire de masse électronique sécurisée, destiné à être relié à un système hôte (H), comprenant au moins :
- un processeur central, une unité à disques électroniques comportant, d'une part, un ensemble de mémoires semiconducteurs, et d'autre part au moins un contrôleur, et un premier et un second bus de type parallèle auxquels sont connectés le processeur central et l'unité à disques de manière à rendre cette dernière accessible au système hôte à la fois par son propre contrôleur d'une part, et par le processeur central via son contrôleur d'autre part,
- une unité à disques de sauvegarde d'un type déterminé, connectée au dit contrôleur, d'une part, et au processeur central, d'autre part, et qui contient des informations strictement identiques à celles écrites dans l'unité à disques électroniques,

est caractérisé en ce que le premier et le second bus sont identiques et physiquement parallèles l'un à l'autre et présentent entre eux une zone de recouvrement à laquelle sont connectés le processeur central et l'unité à disques électroniques,
au moins le processeur central et l'unité à disques électroniques, étant disposés dans une structure physique formée par un panier porte-cartes comportant un fond de panier où sont disposés le premier et le second bus, auxquels sont connectées les cartes portant respectivement le processeur central et l'unité à disques électroniques.

Dans une forme de réalisation préférée de l'invention, l'unité de mémoire de masse électronique a ceci de particulier que les deux bus sont identiques et parallèles l'un à l'autre et présentent entre eux une zone de recouvrement sur laquelle sont connectées la carte-mère de l'unité à disques électroniques et le processeur central. De préférence, la zone de recouvrement est divisée en deux parties pouvant recevoir chacune au moins une unité à disques électroniques, chacune des deux parties étant alimentée en énergie électrique par une alimentation distincte de celle alimentant l'autre partie.

Dans le but d'accroître la sécurité d'accès aux informations mémorisées dans l'unité de mémoire électronique selon l'invention, celle-ci comprend au moins une unité de mémoire à disque rotatif de sauvegarde connectée au contrôleur de l'unité à disques électroniques et au processeur central. Ainsi formée, l'unité de mémoire selon l'invention constitue un sous-système appartenant à un système informatique plus vaste.

Les caractéristiques et avantages de la présente invention apparaîtront dans la description suivante donnée à titre d'exemple non limitatif et en se référant aux dessins annexés.

Sur ces dessins :
- La figure 1 composée des figures 1A et 1B montre une unité à disques électroniques selon l'Art Antérieur,
- La figure 2 montre le schéma électrique simplifié d'une unité de mémoire électronique selon l'invention comportant deux bus de type MULTIBUS II et deux unités de disques électroniques connectées à ces deux bus,
- La figure 3 formée des figures 3A et 3B montre la structure physique en forme de panier d'une unité de mémoire électronique à deux bus selon l'invention comprenant une seule unité à disques électroniques dont le schéma électrique est analogue à celui montré à la figure 2, la figure 3A étant une vue de 3/4 en perspective, la figure 3B montrant un exemple de connecteur permettant de connecter la mémoire à disques de sauvegarde à l'unité à disques électroniques et au processeur central.
- La figure 4 est une vue de face de la structure physique montrée à la figure 3A.
- La figure 5 composée des figures 5A et 5B montre plus en détail la structure fonctionnelle de l'unité de mémoire électronique selon l'invention, montrée à la figure 3A.
- La figure 6 montre un second exemple de réalisation d'une structure physique d'une unité de mémoire électronique comprenant une seule unité à disques électroniques, dont le schéma électrique est analogue à celui de la figure 2.

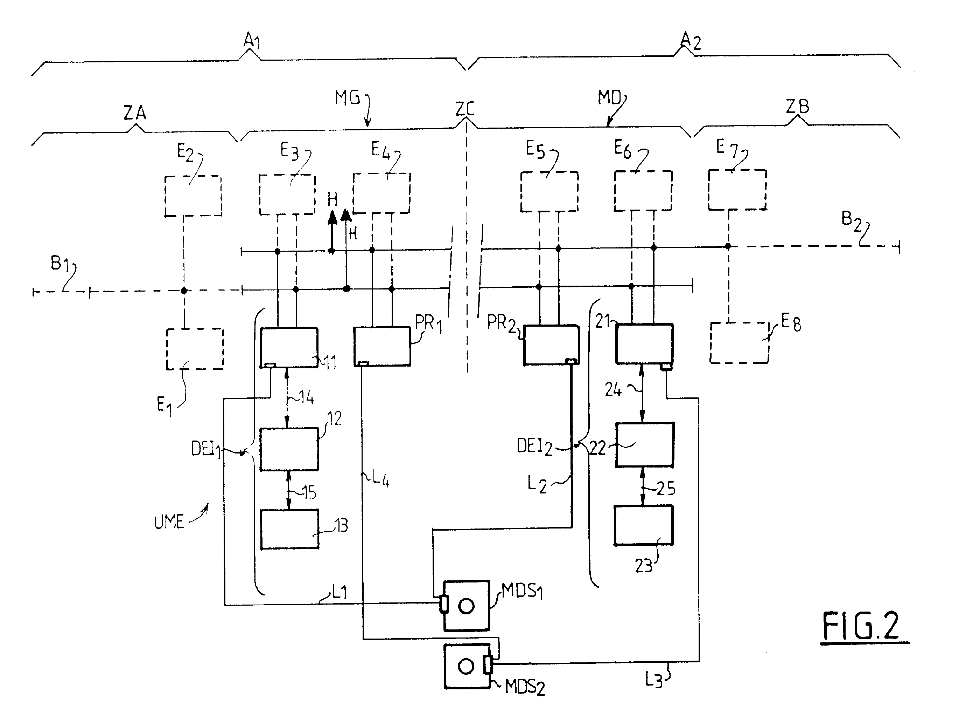

On considère la figure 2 qui montre l'unité de mémoire électronique UME selon l'invention.

L'unité UME peut être considérée comme un sous-système informatique de mémoire de masse appartenant à un système informatique plus vaste dont la partie centrale est communément appelée système hôte H.

L'unité UME comprend deux parties MG et MD. Chacune de ces parties est alimentée en énergie électrique par deux alimentations indépendantes A₁ et A₂.

Elle est construite autour de deux bus identiques, parallèles l'un à l'autre, de préférence de type MULTIBUS II, désignés par B₁ et B₂.

Les deux bus B₁ et B₂ peuvent être soit totalement en regard l'un de l'autre, soit comporter trois zones différentes, à savoir :
- une zone commune ZC où les deux bus sont en regard l'un de l'autre physiquement,
- deux zones ZA et ZB où les deux bus ne sont pas en regard l'un de l'autre.

On peut donc dire que suivant le cas les deux bus B₁ et B₂ sont en recouvrement total ou partiel. L'unité UME comprend dans sa première partie MG, une unité de disques électroniques DEI₁ et un processeur central PR₁, et dans sa seconde partie MD une seconde unité de disques électroniques DEI₂ et un processeur central PR₂.

Les unités de disques électroniques DEI₁ et DEI₂ et les processeurs PR₁ et PR₂ sont connectés, chacun, aux deux bus B₁ et B₂, et ce, dans la zone de recouvrement commune ZC.

De préférence, l'unité de mémoire électronique UME est raccordée au système hôte H dans cette zone commune ZC, ainsi qu'on peut le voir à la figure 2 (dans la partie MG, entre le processeur PR₁ et la première unité de disques électroniques DEI₁).

L'unité de mémoire électronique UME peut également comporter dans sa partie MG, des éléments constitutifs supplémentaires E₃ et E₄, et dans sa partie MD des éléments supplémentaires E₅ et E₆. Les éléments E₃, E₄, E₅, E₆, sont également connectés dans la zone commune ZC, à la fois aux deux bus B₁ et B₂. Les éléments E₃ et E₄ peuvent être par exemple un autre processeur central et une autre unité à disques électroniques respectivement, et il en est de même pour les éléments E₆ et E₅.

Le nombre d'éléments de l'unité UME dépend de la capacité mémoire que l'on affecte à cette unité, et également de l'importance que l'on accorde à la disponibilité du système.

Il est clair que dans le cas où la zone de recouvrement ZC n'est que partielle, on peut connecter dans les zones ZA et ZB, d'autres éléments tels que E₁ et E₂ dans la première et E₇ et E₈ dans la seconde. Les éléments E₁, E₂, E₇, E₈ ne sont connectés qu'à un seul des deux bus à savoir B₁ pour E₁ et E₂ et B₂ pour E₇ et E₈.

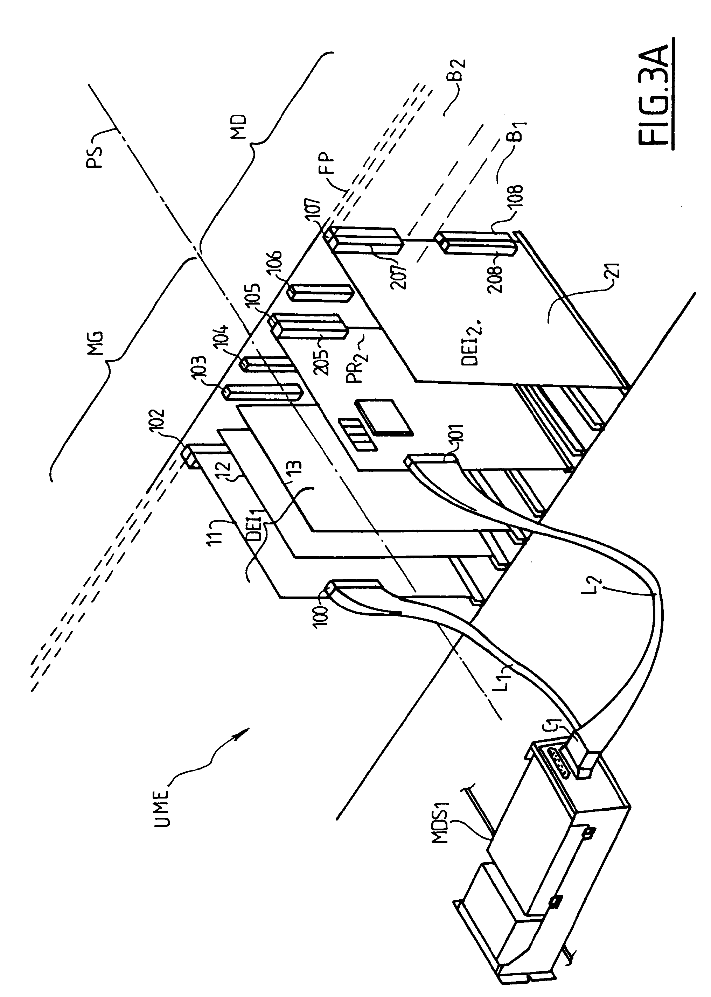

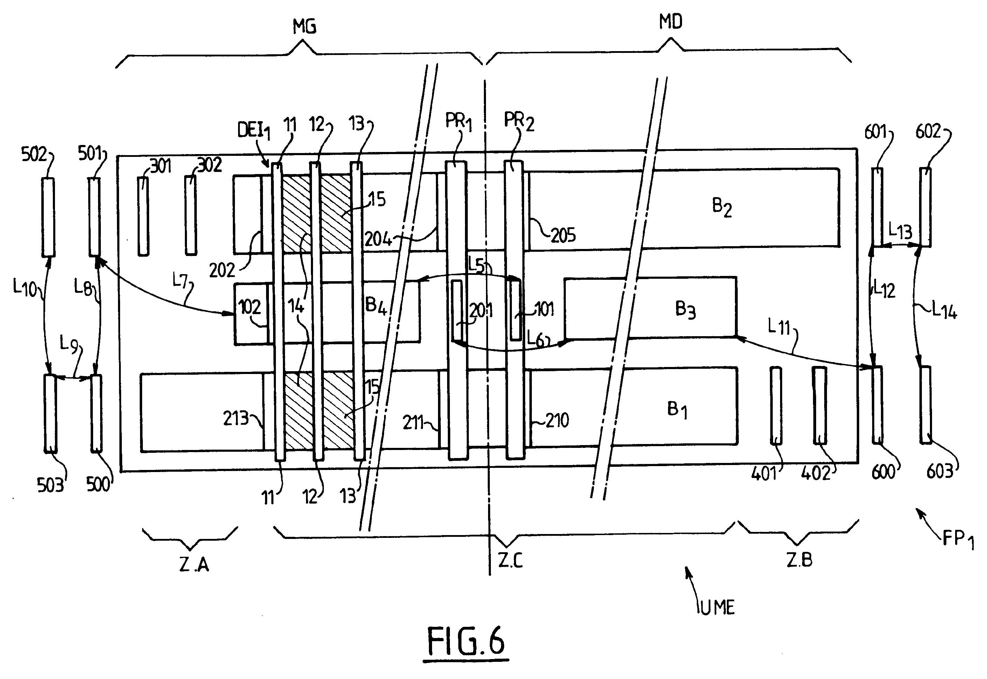

Pour la suite de la description, on décrira, en relation avec les figures 3, 4, et 5, l'unité UME selon l'invention dans le cas où la zone de recouvrement ZC est totale, c'est-à-dire, dans le cas où les deux bus B₁ et B₂ sont totalement en regard l'un de l'autre, et en relation avec la figure 6, l'unité UME dans le cas où la zone de recouvrement est partielle.

Les unités de disques électroniques DEI₁ et DEI₂ comprennent respectivement, dans l'exemple de réalisation montré à la figure 2, une carte-mère 11 et au maximum deux cartes-filles 12 et 13 pour la première et une carte-mère 21 et au maximum deux cartes-filles 22 et 23 pour la seconde. La carte-mère 11 est connectée à la carte-fille 12 par l'intermédiaire de moyens de connexion 14 alors que la carte-fille 12 est connectée à la carte-fille 13 par des moyens de connexion 15. De même, la carte-mère 21 est connectée à la carte-fille 22 par des moyens de connexion 24, et les deux cartes-filles 22 et 23 sont reliées entre elles par des moyens de connexion 25.

La structure de DEI₁ et celle de DEI₂ peuvent être différentes, tant au niveau du nombre de carte-filles (1 ou 2) et du nombre de RAM et de colonnes de RAM, (et donc au niveau de leur capacité mémoire) qu'au niveau du contenu des informations qui y sont enregistrées.

Afin d'accroître le plus possible la sécurité d'enregistrement des données à l'intérieur des différents éléments composant l'unité de mémoire électronique UME (on dit également afin de sécuriser les données), celle-ci comporte, une première mémoire à disques rotatifs de sécurisation des données (ou encore de sauvegarde), désignée par MDS₁, reliée d'une part à la carte-mère 11 par l'intermédiaire d'une liaison L₁ et d'autre part au processeur PR₂ par une liaison L₂. De la même façon, l'unité UME comporte une seconde mémoire à disques rotatifs de sauvegarde, à savoir MDS₂ reliée d'une part à la carte-mère 21 par l'intermédiaire d'une liaison L₃ et au processeur PR₁ par une liaison L₄. La manière dont MDS₁ et MDS₂ sont connectés respectivement à L₁ et L₂, L₃ et L₄ est illustrée au moyen de la figure 3B décrite plus loin. Chacune des liaisons est du type SCSI/IPI, c'est-à-dire constituée par un ensemble de 25 paires torsadées aux extrémités desquelles se trouvent des connecteurs 50 points. La nécessité de sécuriser les données au moyen de mémoire à disques rotatifs telles que MDS₁ et MDS₂, provient du fait que si les mémoires semi-conductrices sont des mémoires RAM, les données qui y sont enregistrées sont perdues dès qu'il y a absence d'alimentation électrique. Les données qui sont donc contenues à l'intérieur des cartes-filles 12 et 13 d'une part, 22 et 23 d'autre part sont également enregistrées respectivement, par exemple au moment où l'on écrit les données dans les cartes-filles, sur les pistes d'enregistrement circulaires des disques magnétiques rotatifs des mémoires MDS₁ ET MDS₂.

Les processeurs centraux PR₁ et PR₂ sont les maîtres d'oeuvres, respectivement des différents éléments situés dans les parties MG et MD. (Dans le cas où l'unité UME ne comporte qu'un seul processeur central et une seule unité de disques électroniques, PR₂ et DEI₁, par exemple, le processeur PR₂ est maître d'oeuvre de tous les éléments situés dans les parties MG et MD). Les processeurs centraux chargent les programmes de mise en oeuvre des différents éléments inclus dans les parties MG et MD dans ceux-ci afin qu'ils puissent remplir les fonctions qui leur sont dévolues. Les processeurs PR₁ et PR₂ vont chercher ces programmes qui sont stockés, par exemple, dans les mémoires à disques rotatifs MDS₂ et MDS₁. Dans ce cas, ces dernières ont donc une double fonction, à savoir d'une part la sauvegarde des informations stockées dans les unités DEI₁ et DEI₂ et d'autre part le stockage des programmes de mise en oeuvre précités. Il est clair que ces derniers pourraient être stockés dans une mémoire à disques spéciale, dite mémoire à disques système reliée aussi bien au processeur PR₁ qu'au processeur PR₂.

On considère désormais les figures 3A et 4 qui montrent une vue partielle du fond de panier FP du panier contenant en partie la structure physique de l'unité de mémoire électronique UME montrée à la figure 2, à savoir l'unité de disques électroniques DEI₁ et le processeur PR₂, ainsi que la carte-mère 21 dont les cartes-filles associées 22 et 23 ne sont pas représentées pour simplifier la compréhension des figures 3A et 4. On remarque que l'unité de mémoire électronique est constituée par une seule et même structure physique, à savoir le panier PA dont on a seulement représenté, pour des raisons évidentes de simplification, le fond de panier FP aux figures 3A et 4.

Le fond de panier FP présente un plan de symétrie PS perpendiculaire à son plan et à sa grande dimension. Il a une forme sensiblement rectangulaire et un centre de symétrie O qui est bien entendu, le centre du rectangle.

De part et d'autre du plan de symétrie PS se trouve respectivement chacune des deux parties MG et MD de l'unité de mémoire UME. Le bus B₂ est disposé dans la partie supérieure du fond de panier FP, aux figures 3A et 4, alors que le bus B₁ est disposé dans sa partie inférieure.

Le fond de panier FP est montré, sur ces figures, comprenant notamment, dans sa partie supérieure et de gauche à droite, 6 connecteurs femelles, 102 à 107, et dans sa partie inférieure de droite à gauche 6 connecteurs femelles 108 à 113 (à la figure 3A on ne voit que le connecteur 108). Les connecteurs 102 à 107 sont reliés électriquement au bus B₂ alors que les connecteurs 108 à 113 le sont au bus B₁. Ces connecteurs sont des modèles à 96 broches (3 rangées parallèles de 32 broches) conformes aux normes définies par l'International Electromechanical Commission, sous la référence 603-2 IEEC 096. Il est clair que les connecteurs mâles correspondant à chacun de ces connecteurs femelles sont définis par la même norme. Le plan de symétrie PS passe entre les connecteurs 104 et 105, 110 et 111.

L'unité de disques électroniques DEI₁ est connectée aux deux bus B₂ et B₁ par l'intermédiaire des deux connecteurs mâles 202 et 213 correspondant aux connecteurs femelles 102 et 113 des mêmes bus. Seule la carte-mère 11 est connectée aux deux bus B₂ et B₁. C'est donc elle qui porte les deux connecteurs 202 et 213. Les deux cartes-filles, ainsi qu'il a été dit plus haut sont connectées entre elles par les moyens de connexion 15 et la carte-fille 12 est connectée à la carte-mère 11 par l'intermédiaire des moyens de connexion 14.

Les moyens de connexion 14, 15, 24, 25 sont constitués par l'association de connecteurs mâle et femelle 160 points, chaque carte-fille portant sur chacune de ses faces respectivement un connecteur mâle et un connecteur femelle.

L'écartement nécessaire à l'ensemble carte-mère 11 et cartes-filles 12-13 est égal au double de l'écartement normalisé entre deux cartes voisines connectées directement aux deux bus B₁ et B₂, soit 2 x 20,32 mm = 40,64 mm.

Les cartes-filles ne comportent pas de connecteur permettant de les relier directement aux deux bus B₂ et B₁. Les connecteurs mâles 202 à 207, et 208 à 213 sont de même type à savoir le type P₁ normalisé par la norme IEEE 1296 précitée. L'unité à disques DEI₂, dont on n'a représenté que la carte-mère 21 est connectée aux bus B₂ et B₁ par l'intermédiaire des connecteurs mâles 207 et 208 et femelles 107 et 108. Les deux cartes-filles 22 et 23 qui ne sont pas représentées aux figures 3A et 4 sont en fait disposées à la gauche de la carte-mère 21, dans l'espace situé entre les connecteurs 106 et 107. Le processeur PR₁, également non représenté pour rendre plus claires les figures 3A et 4 est en fait connecté aux connecteurs 104 et 111 et est donc situé entre le processeur PR₂ et la carte-fille 13, dans la partie gauche MG.

La carte-mère 11 est reliée à la liaison L₁ par exemple par l'intermédiaire du connecteur 50 points 100 (norme ANSI). Le connecteur 100 est monté sur la partie arrière de la carte 11, (opposée à la partie de cette carte qui comporte les connecteurs la reliant aux bus B₁ et B₂). De même, la liaison L₂ est connectée au processeur PR₂ par l'intermédiaire du connecteur 101 identique à 100 et disposé sur la carte correspondante de la même manière, sur la partie arrière de celle-ci.

La figure 3B montre un mode de réalisation du connecteur C₁ permettant de relier ensemble les deux liaisons L₁ et L₂. C₁ est par exemple un connecteur mâle venant s'insérer dans un connecteur femelle correspondant situé sur la partie arrière du boîtier contenant la mémoire à disques de sauvegarde MDS₁. Le connecteur C₁ est montré dans sa partie située à l'intérieur d'un boîtier de connexion (non représenté). Un tel connecteur C₁ comprend un circuit imprimé CI₁, ayant une forme carrée ou rectangulaire, deux barrettes auto-dénudantes BA₁ et BA₂, parallèles l'une à l'autre, soudées sur CI₁, par exemple du type 8603 de la Société SOURIAU, et un connecteur CN₁, par exemple de type subD (par exemple fabriqué par les Sociétés 3M, AMP, ANSLEY, etc ...).

Les extrémités des 50 fils des paires torsadées constituant respectivement les liaisons L₁ et L₂ sont insérées dans les barrettes BA₁ et BA₂. Il est clair que c'est le circuit imprimé lui-même, par l'intermédiaire de ses conducteurs internes qui assure la liaison électrique entre les extrémités des 50 fils constituant les câbles 11 et 12 et les 50 points que possède le connecteur CN₁, lequel est soudé sur l'une des extrémités du circuit imprimé CI₁. Ainsi qu'on peut le voir sur la figure 3B, la longueur du connecteur CN₁ est égale à la dimension du côté du circuit imprimé CI₁, dans le cas où celui-ci est de forme carrée et à la largeur de celui-ci s'il est de forme rectangulaire. Les deux barrettes auto-dénudantes BA₁ et BA₂ sont disposées sur le côté du circuit imprimé perpendiculairement à la longueur du connecteur CN₁. Autrement dit, les deux barrettes auto-dénudantes sont parallèles aux côtés du carré constituant le circuit imprimé CI₁ qui sont horizontaux sur la figure 3B.

Il est clair que l'ensemble des connecteurs femelles 102 à 107 d'une part, 108 à 113 d'autre part ont des axes de symétrie parallèles entre eux et parallèles à la longueur du fond de panier FP. Par ailleurs, tout connecteur de l'ensemble 102 à 107 et tout connecteur correspondant de l'ensemble 108 à 113 ont même axe de symétrie vertical parallèle à la petite dimension du fond de panier.(largeur du rectangle constituant celui-ci). Il est clair que ces dispositions relatives des connecteurs de chacun des deux ensembles 102 à 107, 108 à 113 est indispensable pour permettre une connexion correcte des différentes cartes 11, 12, 13, 21, 22, 23, PR₁ et PR₂ à l'intérieur du panier PA.

L'ensemble des cartes situées dans la partie MD de l'unité UME est vu du côté des cartes qui comprend les composants intégrés de celles-ci, alors que l'ensemble des cartes situées dans la partie MG est vu du côté opposé à celui contenant les composants intégrés, c'est-à-dire du côté soudures. Ceci est dû au fait que les cartes situées dans la partie MD sont montées à l'envers des cartes situées dans la partie MG. Ainsi, les cartes 11, 12, 13, PR₁ sont-elles respectivement symétriques des cartes 21, 22, 23, PR₂ par rapport au plan de symétrie PS et par rapport au centre de symétrie O du fond de panier FP.

La disposition relative des cartes des parties MD et MG fait qu'il est impossible d'insérer une carte dans le mauvais sens. On ne peut donc insérer qu'une carte telle que 21 dans la partie MG et telle que 11 dans la partie MD. Ceci est dû à la disposition des connecteurs sur les cartes. En effet, si l'on regarde le fond de panier, on voit que les connecteurs des cartes situées dans la partie MD sont situés à droite des cartes alors que les connecteurs des cartes situées dans la partie MG sont situés à gauche des cartes. L'insertion d'une carte devant aller normalement dans la partie MD, à l'intérieur de MG et réciproquement, aurait donc pour résultat que les connecteurs de celles-ci buteraient sur les connecteurs d'une carte voisine et qu'on ne pourrait insérer la carte plus profondément dans le panier, rendant ainsi impossible la connexion.

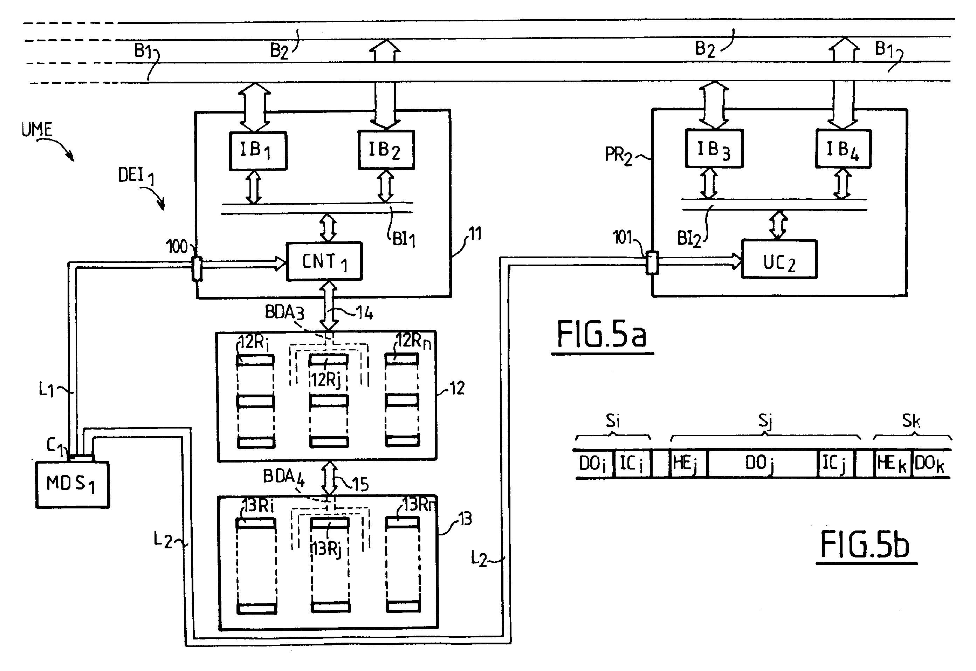

On considère la figure 5A.

La carte-mère 11 comprend notamment, une interface IB₁ de communication avec le bus B₁, une interface de communication IB₂ avec le bus B₂, et un contrôleur CNT₁ de l'unité de disques électroniques DEI₁, ces différents éléments à savoir IB₁ et IB₂, CNT₁ échangeant des informations par l'intermédiaire du bus interne BI₁ de la carte-mère 11.

La carte-fille 12, qui constitue un premier plan mémoire comporte une pluralité de colonnes de mémoires RAM par exemple, à savoir les colonnes 12 R₁, ... 12 Rⱼ, ... 12 Rₙ. De même, la carte-fille 13 qui constitue un second plan mémoire de l'unité de disques électroniques DEI₁ comprend une pluralité de colonnes de mémoires semi-conductrices RAM, à savoir 13 R₁,... 13 Rⱼ, 13 Rₙ. La structure interne des cartes 12 et 13 est identique à celle décrite pour la carte 3 de la figure 1.

Le processeur central PR₂ comprend deux interfaces de communication respectivement avec les bus B₁ et B₂, à savoir IB₃ et IB₄, un bus de communication BI₂ et une unité centrale UC₂.

Ainsi, on peut voir que l'unité de disques électroniques DEI₁ est accessible par l'unité centrale du processeur PR₂.

Les interfaces IB₁, IB₂, IB₃, IB₄ sont de même type et constituées selon la norme IEEE 1296 par un coprocesseur, par exemple de type VL 82c389 (fabriqué par la Société INTEL) communiquant par mode message avec les autres éléments constitutifs fonctionnels de l'unité de mémoire électronique UME et le système hôte H.

Lorsque le système hôte H ou le processeur PR₂ désire inscrire des informations dans l'unité de disques électroniques DEI₁, les informations transitent par l'un des deux bus B₁ ou B₂, passent par l'interface entre IB₁ (IB₂) avant d'être transmises au contrôleur CNT₁. Celui-ci, en fonction des endroits disponibles dans les plans mémoires des cartes-filles 12 et 13, y inscrit les informations. Dans le même temps, il envoie ces mêmes informations sur la mémoire à disques de sauvegarde MDS₁ via les connecteurs 100 et C₁ et la liaison L₁. Ces mêmes informations sont donc inscrites sur une ou plusieurs pistes circulaires de l'un des disques magnétiques de cette mémoire. Il est clair que l'écriture des informations dans les plans mémoire des cartes-filles 12 et 13 d'une part et sur l'une des pistes de l'un des disques de la mémoire à disque de sauvegarde MDS n'a pas lieu exactement au même instant puisque le temps d'accès aux mémoires semi-conductrices et aux disques rotatifs n'est pas le même. Par conséquent, ces informations seront écrites sur l'un des disques magnétiques de la mémoire à disques de sauvegarde MDS₁ avec un certain retard dû au temps d'accès plus grand, par rapport au moment où ces informations sont écrites dans les plans mémoire des cartes-filles 12 et 13.

Il est clair que ce qui vient d'être décrit ci-dessus pour l'unité DEI₁ est également valable pour l'unité DEI₂.

En ce qui concerne la lecture des informations, elle s'effectue directement dans les plans mémoire des cartes-filles 12 et 13 avec des temps d'accès extrêmement courts, de l'ordre de quelques dixièmes de millisecondes, sous le contrôle du contrôleur CNT₁.

La figure 5b montre sous quelle forme sont enregistrées les données dans les cartes 12 et 13. Les données sont divisées en plusieurs blocs ou secteurs Sᵢ, Sⱼ, Sₖ contenant le même nombre d'octets. Dans tout secteur Sⱼ, on trouve à écrire successivement (ou lire) un préambule HEⱼ (Header, en anglais), un bloc de données DOⱼ, et un postambule ICⱼ. L'ensemble des informations d'un secteur est inscrit dans des emplacements mémoires dont les adresses se suivent, par exemple d'une unité. Ainsi, par exemple, un secteur Sᵢ, sera écrit aux adresses 301, 302, ...350, le secteur Sⱼ aux adresses 351 à 400, etc ... . Le préambule contient les adresses de début et de fin de l'enregistrement du secteur Sⱼ et le postambule des informations de vérification de l'intégrité des données pour vérifier si tous les octets du secteur Sⱼ enregistrés sont corrects.

Les données sont écrites sous un format de 39 bits, soit 32 bits utiles répartis en 4 octets ajoutés à 7 bits ECC (Error Corrector Code) de correction d'erreurs (ce mode de correction d'erreurs est conventionnellement utilisé dans les mémoires RAM dynamiques). A chaque adresse d'une mémoire RAM, on écrira donc 39 bits. Par suite, les bus BDA₃ et BDA₄ des cartes-filles 12 et 13 qui transportent les informations provenant de ou allant vers celles-ci (bus qui jouent un rôle analogue au bus BDA de la figure 1) se composent en fait d'un bus de données sur 39 bits et d'un bus d'adresse.

Les informations de vérification de l'intégrité des données du postambule sont communément appelées CKS, (check sum en anglais) et représentent la somme mathématique logique de tous les mots de 32 octets contenus dans la partie DOᵢ du secteur Sᵢ. A la lecture, la somme des octets lus dans DOᵢ est recalculée (soit par le contrôleur CNT₁, soit par le système hôte par exemple) et comparée à la valeur lue de CKS.

Cette organisation d'écriture des informations par secteur, et la répartition de celles-ci à l'intérieur des secteurs (préambule, données, postambule avec CKS) est calquée sur l'organisation des informations à l'intérieur des pistes magnétiques circulaires des disques rotatifs d'une mémoire à disques conventionnelle: ceci permet d'écrire et de lire les informations avec la sécurité la plus grande possible (on dit encore: ceci permet de sécuriser l'ensemble des données) :
1/ par protection contre les erreurs de contenu des données, ce qui est dû à la présence des 7 bits de correction d'erreur ECC accompagnant 4 octets.
2/ par protection contre les erreurs d'adressage :
   - par vérification à la lecture du préambule (qui contient les adresses de début et de fin d'enregistrement du secteur considéré).
   - par vérification à la lecture du contenu du postambule.

Dans le cas d'une commande d'écriture d'informations dans les plans mémoire des cartes 12 et 13, l'acquittement par le contrôleur CNT₁ d'une commande d'écriture vers le système hôte H (vers le processeur central) peut s'effectuer de deux manières :
- lorsque l'enregistrement des informations a été effectué dans le plan mémoire correspondant, sans attendre que celles-ci aient été complètement enregistrées sur l'un des disques magnétiques de la mémoire à disques de sauvegarde MDS.
- lorsque l'enregistrement des données est non seulement effectué dans les plans mémoire des cartes 12 et 13 mais également sur l'un des disques magnétiques de la mémoire de sauvegarde MDS₁: la perte de performance du point de vue temps d'accès n'est pas aussi importante que l'on peut le penser car le disque magnétique n'est utilisé que pour les opérations d'écriture, ce qui ne représente en moyenne que 20 à 40% des opérations d'entrée/sortie de l'unité de mémoire électronique UME.

Ainsi, quel que soit le système d'acquittement utilisé, on met à jour systématiquement, lors de chaque opération d'écriture, l'inscription des informations alors écrites dans les plans mémoire sur la mémoire à disques de sauvegarde. Ce système présente de bien meilleures garanties de sécurisation des données que celui fréquemment employé dans la pratique courante, à savoir l'écriture des informations dans la mémoire à disques de sauvegarde uniquement dans le cas de coupures d'alimentation électriques : on rappelle que ce mode de sauvegarde est utilisé lorsque l'on remédie au problème de la volatilité des données dû à l'utilisation de mémoires semi-conductrices de type RAM en reliant celles-ci à un ensemble de batteries. (Ce qui est le cas pour les mémoires électroniques selon l'Art Antérieur précitées).

L'autre avantage du sous-système de mémoire de masse UME selon l'invention est de pouvoir constituer une sécurisation supplémentaire: en effet, la mémoire à disques magnétiques spécifique de sauvegarde est accessible également par le processeur PR₂ grâce à la liaison L₂. Cet accès à la mémoire de sauvegarde MDS₁ n'est utilisé qu'en cas de panne de la carte-mère 11, ou en cas de panne totale ou partielle du plan mémoire des cartes-filles 12 et 13. On voit donc qu'en cas de panne totale du contrôleur CNT₁ ou de coupures de la tension d'alimentation de celui-ci, l'accès par le processeur PR₂ permet au système hôte H l'accès aux données normalement effectué par le contrôleur CNT₁, même si dans ce cas les performances sont dégradées du point de vue temps d'accès.

On voit que les avantages de l'invention sont donc une grande disponibilité due au double accès aux données contenues dans chacune des unités de disques électroniques DEI₁ et DEI₂ par les deux bus B₁ et B₂, et d'autre part une grande sécurisation des données due d'une part à la présence de la mémoire à disques de sauvegarde accessible aussi bien par CNT₁ que par PR₂, (cette mémoire de sauvegarde est donc également double accès) et d'autre part à l'organisation d'écriture des informations dans les mémoires RAM calquée sur celle des mémoires à disques rotatifs.

Par ailleurs, l'unité de mémoire électronique selon l'invention présente de grands avantages dus à son faible encombrement, à son temps d'accès très faible, et à son moindre coût par rapport aux unités de mémoires électroniques selon l'art antérieur.

On considère la figure 6 qui représente un autre exemple de réalisation d'une unité de mémoire électronique UME selon l'invention.

Cette unité est représentée avec son fond de panier FP₁, lequel comprend deux bus de type parallèle MultibusII, B₁ et B₂, disposés respectivement dans la partie inférieure et dans la partie supérieure du fond de panier, parallèles l'un à l'autre et décalés l'un par rapport à l'autre de telle manière qu'ils présentent une zone de recouvrement commune ZC comportant, dans l'exemple de réalisation décrit ici, 16 connecteurs, et deux zones ZA et ZB comportant deux connecteurs. Le fond de panier FP₁ porte, dans le prolongement du bus B₂, deux connecteurs 301 et 302, par exemple identiques aux connecteurs du bus B₂ (102 à 107, voir figure 3A) et ayant le même écartement. De la même façon le fond de panier FP₁ porte dans le prolongement du bus B₁ deux connecteurs 401 et 402 identiques au connecteur du bus B₁ ayant le même écartement. De la sorte, le nombre total de connecteur du fond de panier FP₁ est de 20.

On a représenté à la figure 6 l'unité de disques électroniques DEI₁ comprenant la carte-mère 11 et les cartes-filles 12 et 13, les moyens de connexion 14 et 15, et les connecteurs 202 et 213, disposés dans la partie gauche MG de l'unité UME, le processeur PR₁, disposé également dans cette partie gauche MG et connecté aux deux bus B₂ et B₁ par l'intermédiaire des connecteurs 204 et 211. On a également représenté le processeur PR₂ disposé dans la partie droite MD et connecté aux bus B₂ et B₁ par l'intermédiaire des connecteurs 205 et 210. Le processeur PR₂ est représenté muni de son connecteur 101 permettant de le relier à une liaison de type SCSI 50 points paire torsadée. De même, le processeur PR₁ est représenté avec son connecteur 201, identique à 101.

Le fond de panier FP₁ comporte en outre deux bus B₃ et B₄ de type SCSI, c'est-à-dire comprenant 50 points, c'est-à-dire véhiculant 50 signaux (il s'agit donc ici de bus disposés sur le circuit imprimé), de même longueur et permettant de connecter les différents éléments composant l'unité de mémoire électronique UME à des mémoires à disques de sauvegarde. Le processeur PR₂ est connecté par l'intermédiaire d'une liaison différentielle filaire SCSI, 50 points, L₅, au connecteur 101 et au bus B₄ (la liaison L₅ est évidemment supposée ici munie en ses deux extrémités de connecteur 50 points permettant de la relier au bus B₄ et au connecteur 101).

De même, le processeur principal PR₁ est-il relié par l'intermédiaire de la liaison de type SCSI L₆ au bus B₃ et au connecteur 201. L'unité du disque électronique DEI₁ est connectée au bus B₄ par l'intermédiaire du connecteur 102.

Dans une forme de réalisation préférée de l'unité de mémoire électronique UME selon l'invention montrée à la figure 6, on peut disposer de part et d'autre du fond de panier FP₁, quatre emplacements pour des mémoires à disques rotatifs 3 pouces 1/2 enfichables, ces mémoires à disques étant de plus en plus répandues sur le marché. A gauche du fond de panier FP₁, on trouve les quatre emplacements 500 à 503 pouvant recevoir quatre mémoires à disques 3 pouces 1/2, alors qu'à droite de ce même fond de panier, on trouve les quatre emplacements 600 à 603.

Le bus B₄ est relié à l'emplacement 501 par l'intermédiaire d'une liaison 50 points L₇ alors que le bus B₃ est relié à l'emplacement 600 par une liaison 50 points L₁₁. Lorsque les emplacements 500 à 503 d'une part, 600 à 603 d'autre part sont munis de leurs mémoires à disques 3 pouces 1/2, celles-ci sont reliées par l'intermédiaire de liaison 50 points, telle que L₈ entre les emplacements 501 et 500, L₉ entre 500 et 503, L₁₀ entre 503 et 502 d'une part et d'autre part L₁₂ entre 600 et 601, L₁₃ entre 601 et 602, L₁₄ entre 602 et 603. Les connecteurs permettant de relier les différentes liaisons L₇ à L₁₀ d'une part, L₁₁ à L₁₄ d'autre part aux différentes mémoires à disques 3 pouces 1/2 sont des connecteurs tel que celui montré à la figure 3B.

Les mémoires à disques 3 pouces 1/2 que l'on peut disposer aux emplacements 500 à 503 et 600 à 603 peuvent constituer des mémoires à disques de sauvegarde, soit pour la seule unité à disque électronique DEI₁, en ce qui concerne les mémoires à disques disposées aux emplacements 500 à 503, soit pour la seule unité de disque électronique DEI₂ pour les unités de mémoires à disques disposées aux emplacements 600 à 603, soit encore des mémoires à disques de sauvegarde pour les différentes unités à disques électroniques connectées dans la partie gauche MG, pour les emplacements 500 à 503, ou les unités à disques électroniques disposées dans la partie droite MD, pour les emplacements 600 à 603.

Il est clair que l'unité UME représentée à la figure 6 présente les même avantages que celle représentée aux figures précédentes, elle est de plus beaucoup plus compacte au point de vue encombrement et ses performances au point de vue temps d'accès sont encore améliorées.

## Revendications

1. Sous-système informatique à mémoire de masse électronique sécurisée, destiné à être relié à un système hôte ( H ), comprenant au moins :
- un processeur central ( PR₁-PR₂ ), une unité à disques électroniques (DEI₁-DEI₂ ) comportant, d'une part, un ensemble (11-12-13, 21-22-23)) de mémoires à semi-conducteurs, et d'autre part au moins un contrôleur (CNT₁-CNT₂ ), et un premier et un second bus (B₁-B₂ ) de type parallèle auxquels sont chacun connectés à la fois le processeur central et l'unité à disques de manière à rendre cette dernière accessible au système hôte (H) à la fois par son propre contrôleur d'une part, et par le processeur central via son contrôleur d'autre part,
- une unité à disques de sauvegarde (MDS₁-MDS₂) d'un type déterminé, connectée au dit contrôleur, d'une part, et au processeur central, d'autre part, et qui contient des informations strictement identiques à celles écrites dans l'unité à disques électroniques,
caractérisé en ce que le premier et le second bus sont identiques et physiquement parallèles l'un à l'autre et présentent entre eux une zone de recouvrement (ZC) à laquelle sont connectés le processeur central et l'unité à disques électroniques,
au moins le processeur central et l'unité à disques électroniques, étant disposés dans une structure physique formée par un panier porte-cartes comportant un fonds de panier (FP) où sont disposés le premier et le second bus, auxquels sont connectées les cartes portant respectivement le processeur central et l'unité à disques électroniques.

2. Sous-système informatique selon la revendication 1, caractérisée en ce que l'unité à disques électroniques comprend une carte-mère (11, 21) contenant le contrôleur (CNT₁, CNT₂) et une pluralité de cartes-filles (12-13, 22-23) constituant autant de plans mémoire et connectées entre elles deux à deux, la première d'entre elles étant connectée à la carte-mère, laquelle est connectée au premier et au second bus (B₁, B₂).

3. Sous-système informatique selon la revendication 2 caractérisée en ce que la la carte-mère (11, 21) de l'unité et le processeur central sont connectés à la zone de recouvrement (ZC).

4. Sous-système informatique selon la revendication 3, caractérisée en ce que la zone de recouvrement (ZC) est divisée en deux parties (MG, MD) pouvant recevoir au moins chacune une unité de disques électroniques (DEI₁, DEI₂) et alimentée en énergie électrique par deux alimentations indépendantes l'une de l'autre (A₁, A₂).

5. Sous-système informatique selon les revendications 1 à 4, caractérisée en ce que le fond de panier (FP) a une forme sensiblement rectangulaire ayant un centre de symétrie O et un plan de symétrie (PS) perpendiculaire au plan du fond de panier et à sa grande dimension, et en ce que le fond de panier (FP) comprend une première rangée de connecteurs (102 à 107) du premier bus (B₁) ayant tous un même premier axe de symétrie parallèle à la grande dimension du fond de panier, et une seconde rangée de connecteurs (108 à 113) du second bus (B₂) ayant un second axe de symétrie parallèle au premier, les connecteurs de la première et de la seconde rangée étant alignés deux à deux selon une même ligne parallèle à la largeur du fond de panier.

6. Sous-système informatique électronique suivant la revendication 5 caractérisée en ce que l'organisation de la répartition des informations, tant à l'intérieur des plans mémoire des cartes-filles (12, 13) qu'à l'intérieur des pistes circulaires des disques rotatifs de la mémoire de sauvegarde est faite sous forme d'une pluralité de secteurs (Sᵢ, Sⱼ ...) distincts comprenant chacun un préambule (HEᵢ, HEⱼ) contenant l'adresse de début et de fin du secteur, une partie centrale (DOᵢ, DOⱼ) contenant les données proprement dites et un postambule (ICᵢ, ICⱼ) contant des informations (CKS) de vérification de l'intégrité de données.

7. Sous-système informatique selon la revendication 5, caractérisée en ce qu'elle comporte en outre, au moins un bus 50 voies de type SCSI, disposé entre les deux bus de type parallèle de manière à pouvoir y connecter la carte-mère de l'unité à disques électroniques et relié par une liaison de type SCSI au processeur principal, ce dernier bus (B₄, B₃) étant par ailleurs relié par une liaison de type SCSI à au moins une unité à disques de sauvegarde (MDS₁).

8. Sous-système informatique selon la revendication 7 caractérisée en ce qu'elle comporte de part et d'autre du fond de panier (FP₁) des emplacements pour mémoires à disques 3 pouces 1/2 enfichables reliées entre elles par des liaisons de type SCSI et d'autre part par une liaison de même type au bus de typs SCSI (B₄).

9. Système informatique caractérisé en ce qu'il comporte une sous-système informatique selon l'une des revendications 1 à 8.

## Patentansprüche

1. Informatik-Untersystem mit gesichertem elektronischen Massenspeicher, das dazu bestimmt ist, mit einem Zentralsystem (H) verbunden zu werden, und wenigstens enthält:
- einen Zentralprozessor (PR1-PR2), eine elektronische Platteneinheit (DEI1-DEI2), die einerseits eine Gruppe (11-12-13, 21-22-23) von Halbleiterspeichern und andererseits wenigstens eine Steuervorrichtung (CNT1-CNT2) enthält, sowie einen ersten und einen zweiten Bus (B1-B2) des parallelen Typs, an die jeweils sowohl der Zentralprozessor als auch die Platteneinheit in der Weise angeschlossen sind, daß auf diese letztere vom Zentralsystem (H) sowohl durch ihre eigene Steuervorrichtung einerseits als auch durch den Zentralprozessor über ihre Steuervorrichtung andererseits zugegriffen werden kann,
- eine Sicherungsplatteneinheit (MDS1-MDS2) eines gegebenen Typs, die an die Steuervorrichtung einerseits und an den Zentralprozessor andererseits angeschlossen ist und die Informationen enthält, die denen, die in die elektronische Platteneinheit geschrieben sind, strikt gleich sind,
dadurch gekennzeichnet, daß der erste und der zweite Bus völlig gleich sind und physikalisch zueinander parallel sind und eine Zone gegenseitiger Überlappung (ZC) aufweisen, an die der Zentralprozessor und die elektronische Platteneinheit angeschlossen sind,
wobei wenigstens der Zentralprozessor und die elektronische Platteneinheit in einer physikalischen Struktur angeordnet sind, die durch einen Kartenträger-Verdrahtungsrahmen gebildet ist, der einen Verdrahtungsrahmenboden (FP) aufweist, wo der erste und der zweite Bus angeordnet sind, an die die Karten angeschlossen sind, die den Zentralprozessor bzw. die elektronische Platteneinheit tragen.

2. Informatik-Untersystem nach Anspruch 1, dadurch gekennzeichnet, daß die elektronische Platteneinheit eine Mutterkarte (11, 21), die die Steuervorrichtung (CNT₁, CNT₂) enthält, sowie mehrere Tochterkarten (12-13, 22-23) umfaßt, die ebenso viele Speicherebenen bilden und paarweise miteinander verbunden sind, wobei die erste von ihnen an die Mutterkarte angeschlossen ist, welche an den ersten und an den zweiten Bus (B₁, B₂) angeschlossen ist.

3. Informatik-Untersystem nach Anspruch 2, dadurch gekennzeichnet, daß die Mutterkarte (11, 21) der Einheit und der Zentralprozessor an die Überlappungszone (ZC) angeschlossen sind.

4. Informatik-Untersystem nach Anspruch 3, dadurch gekennzeichnet, daß die Überlappungszone (ZC) in zwei Teile (MG, MD) unterteilt ist, wovon jeder wenigstens eine elektronische Platteneinheit (DEI₁, DEI₂) aufnehmen kann, und über zwei voneinander unabhängige Versorgungen (A₁, A₂) mit elektrischer Energie gespeist wird.

5. Informatik-Untersystem nach den Ansprüchen 1 bis 4, dadurch gekennzeichnet, daß der Verdrahtungsrahmenboden (FP) eine im wesentlichen rechtwinklige Form mit einem Symmetriezentrum O und einer zur Ebene des Verdrahtungsrahmenbodens und zu dessen langer Seite senkrechten Symmetrieebene (PS) besitzt und daß der Verdrahtungsrahmenboden (FP) eine erste Reihe von Anschlüssen (102 bis 107) des ersten Busses (B₁), die sämtlich dieselbe erste Symmetrieachse besitzen, die zur langen Seite des Verdrahtungsrahmenbodens parallel ist, sowie eine zweite Reihe von Anschlüssen (108 bis 113) des zweiten Busses (B₂) enthält, die eine zur ersten parallele, zweite Symmetrieachse besitzen, wobei die Anschlüsse der ersten und der zweiten Reihe paarweise auf dieselbe Linie ausgerichtet sind, die zur Breite des Verdrahtungsrahmenbodens parallel ist.

6. Informatik-Untersystem nach Anspruch 5, dadurch gekennzeichnet, daß die Organisation der Verteilung der Informationen sowohl innerhalb der Speicherebenen der Tochterkarten (12, 13) als auch innerhalb der kreisförmigen Spuren der rotierenden Platten des Sicherungsspeichers in Form mehrerer verschiedener Sektoren (Sᵢ, Sⱼ...) gegeben ist, wovon jeder einen Vorsatz (HEᵢ, HEⱼ), der die Anfangs- und die Endadresse des Sektors enthält, einen zentralen Teil (DOᵢ, DOⱼ), der die eigentlichen Daten enthält, sowie einen Nachsatz (ICᵢ, ICⱼ) umfaßt, der die Informationen (CKS) für die Verifikation der Unversehrtheit der Daten enthält.

7. Informatik-Untersystem nach Anspruch 5, dadurch gekennzeichnet, daß es außerdem wenigstens einen 50-Kanal-Bus des SCSI-Typs enthält, der zwischen den beiden Bussen des parallelen Typs in der Weise angeordnet ist, daß hier die Mutterkarte der elektronischen Platteneinheit angeschlossen werden kann, und über eine Verbindung des SCSI-Typs mit dem Hauptprozessor verbunden ist, wobei dieser letztere Bus (B₄, B₃) außerdem über eine Verbindung des SCSI-Typs mit wenigstens einer Sicherungsplatteneinheit (MDS₁) verbunden ist.

8. Informatik-Untersystem nach Anspruch 7, dadurch gekennzeichnet, daß es beiderseits des Verdrahtungsrahmenbodens (FP₁) Plätze für einsteckbare 3,5-Zoll-Speicherplatten enthält, die untereinander über Verbindungen des SCSI-Typs und andererseits über eine Verbindung desselben Typs mit dem Bus des SCSI-Typs (B₄) verbunden sind.

9. Informatiksystem, dadurch gekennzeichnet, daß es ein Informatik-Untersystem nach einem der Ansprüche 1 bis 8 enthält.

## Claims

1. A computer sub-system with a failsafe electronic mass memory, intended to be connected to a host system (H), comprising at least:
- a central processor (PR1-PR2), an electronic disk unit (DEI1-DEI2) comprising, on the one hand, an assembly (11-12-13, 21-22-23) of semiconductor memories and, on the other hand, at least one controller (CNT1-CNT2), and a first and a second bus (B1-B2) of parallel type to which both the central processor and the disk unit are each connected so as to make the latter accessible to the host system (H) both through its own controller on the one hand, and through the central processor via its controller on the other hand,
- a back-up disk unit (MDS1-MDS2) of a given type, connected to said controller, on the one hand, and to the central processor, on the other hand, and which contains information which is strictly identical to that written to the electronic disk unit,
characterised in that the first and the second bus are identical and physically parallel to one another and have between them an overlay area (ZC) to which the central processor and the electronic disk unit are connected,
at least the central processor and the electronic disk unit being arranged inside a physical structure formed by a board-holder compartment comprising a backplane (FP) on which are arranged the first and the second bus, to which are connected the boards carrying respectively the central processor and the electronic disk unit.

2. A computer sub-system according to Claim 1, characterised in that the electronic disk unit comprises a motherboard (11, 21) containing the controller (CNT₁, CNT₂) and a plurality of daughterboards (12-13, 22-23) constituting the same number of memory planes and connected together in twos, the first of them being connected to the motherboard, which is connected to the first and the second bus (B₁, B₂).

3. A computer sub-system according to Claim 2 characterised in that the motherboard (11, 21) of the unit and the central processor are connected to the overlay area (ZC).

4. A computer sub-system according to Claim 3, characterised in that the overlay area (ZC) is divided into two portions (MG, MD) which can each receive at least one electronic disk unit (DEI₁, DEI₂) and which is supplied with electric power by two sources independent of each other (A₁, A₂).

5. A computer sub-system according to Claims 1 to 4, characterised in that the backplane (FP) is substantially rectangular in form, having a centre of symmetry O and a plane of symmetry (PS) perpendicular to the plane of the backplane and to its longest dimension, and in that the backplane (FP) comprises a first row of connectors (102 to 107) of the first bus (B₁) all having the same first axis of symmetry parallel to the longest dimension of the backplane, and a second row of connectors (108 to 113) of the second bus (B₂) having a second axis of symmetry parallel to the first, the connectors of the first and the second row being aligned in twos along the same line parallel to the width of the backplane.

6. An electronic computer sub-system according to Claim 5 characterised in that the organisation of the distribution of information, both within the memory planes of the daughterboards (12, 13) and within the circular tracks of the rotary disks of the backup memory, is made in the form of a plurality of distinct sectors (Sᵢ, Sⱼ...) each comprising a header (HEᵢ, HEⱼ) containing the starting and ending address of the sector, a central portion (DOᵢ, DOⱼ) containing the data proper and a footer (ICᵢ, ICⱼ) containing information (CKS) for verifying the integrity of data.

7. A computer sub-system according to Claim 5, characterised in that it further comprises at least one SCSI-type 50-path bus, arranged between the two parallel-type buses so as to be able to connect thereto the motherboard of the electronic disk unit, and connected via a SCSI-type link to the main processor, this latter bus (B₄, B₃) also being connected via a SCSI-type link to at least one backup disk unit (MDS₁).

8. A computer sub-system according to Claim 7 characterised in that it comprises, on either side of the backplane (FP₁), locations for plug-in 3½ inch disk memories connected together by SCSI-type links and, on the other hand, by a link of the same type to the SCSI-type bus (B₄).

9. A computer system characterised in that it comprises a computer subsystem according to one of Claims 1 to 8.
